# FASCICULE DE BREVET EUROPEEN

(11) **EP 1 094 548 B1**
(45) Date de publication et mention de la délivrance du brevet: **07.06.2006**
(21) Numéro de dépôt: 00402886.6
(22) Date de dépôt: 18.10.2000
(51) Int. Cl.: H01R 4/02, H01M 2/10

(54) **Dispositif de support et de raccordement d'une pile**
Vorrichtung zum elektrischen Verbinden und Befestigen einer Batterie
Device for fixing and connecting of a battery

(30) Priorité: 19.10.1999 FR 9913038
(43) Date de publication de la demande: 25.04.2001
(73) Titulaire: VALEO SECURITE HABITACLE S.A.S., 94042 Créteil Cédex (FR)
(72) Inventeur: Boucard, Olivier, 94100 Creteil (FR); Meunier, Bertrand, 92220 Bagneux (FR); Vuadens, Gilbert, 77130 Montereau (FR)
(74) Mandataire: Rosolen-Delarue, Katell

(56) Documents cités:
- EP-A- 0 427 976
- GB-A- 2 211 982
- GB-A- 2 292 635
- US-A- 4 487 820
- US-A- 4 623 206

## Description

L'invention concerne un dispositif de support et de raccordement électrique d'une pile électrique.

L'invention concerne plus particulièrement un dispositif de support et de raccordement électrique d'une pile électrique sur un circuit électronique.

De plus en plus d'objets de la vie courante nécessite une alimentation électrique pour fonctionner. Un certain nombre d'entre eux pour des raisons fonctionnelles et pratiques, doivent avoir un encombrement minimum, il s'agit notamment des télécommandes à rayonnement infrarouge ou à radiofréquences. Dans ce but, des batteries électriques du type "pile bouton" sont utilisées.

Les piles peuvent être fixées de différentes façons à l'intérieur d'un boîtier.

L'une d'entre elles consiste à réaliser, dans le boîtier, une cavité de taille sensiblement supérieure aux dimensions de la pile puis, à disposer à l'intérieur de cet évidement des pattes conductrices de façon à réaliser le contact électrique entre les bornes de la pile et les éléments qui nécessitent de l'énergie électrique. Cependant, cette solution nécessite un encombrement important, les parois qui délimitent la cavité devant avoir une épaisseur minimum pour maintenir correctement la pile.

Une autre solution consiste à souder sur chacun des pôles, ou bornes, de la pile la première extrémité d'une lame conductrice de support, la seconde extrémité de la lame conductrice étant fixée et reliée électriquement directement à une piste du circuit à alimenter qui comporte une plaque à circuit imprimé.

Les lames réalisent à la fois le support de la pile et son raccordement électrique avec des fils reliés à un dispositif consommateur d'électricité, notamment un circuit intégré. Ce montage assure un encombrement minimum. Cependant, les dispositifs dans lesquels sont montés les piles sont soumis à des chocs et à de nombreuses vibrations. Par exemple, lors de la manipulation d'une télécommande à rayonnement infrarouge pour l'ouverture à distance d'une porte d'un véhicule automobile. Il est fréquent que la soudure entre la première extrémité de la lame conductrice et le pôle de la pile soit sollicitée en fatigue, puis casse suite à ces vibrations.

Dans le but de remédier à ces inconvénients, l'invention propose un dispositif de support et de raccordement d'une pile électrique qui comporte deux pôles, à un circuit électronique, du type qui comprend des pattes de support et de raccordement électrique qui se constituent chacune d'un premier tronçon d'extrémité qui est fixé par soudage et qui est en contact électrique avec un pôle respectif de la pile électrique, et d'un second tronçon d'extrémité qui est fixé sur le circuit électronique et qui est en contact électrique avec une piste de circuit, caractérisé en ce qu'au moins une des pattes de raccordement électrique comporte un tronçon intermédiaire de suspension qui réalise un découplage mécanique entre la pile électrique et le circuit électronique.

Le tronçon intermédiaire de suspension permet d'absorber les vibrations de la pile électrique afin de diminuer les contraintes au niveau de la fixation entre le premier tronçon d'extrémité de la patte de raccordement électrique et la pile.

Selon d'autres caractéristiques de l'invention :
- la pile électrique est cylindrique et chacune de ses faces transversales opposées d'extrémité comporte un pôle électrique ;
- au moins une des pattes de raccordement électrique comporte un premier tronçon d'extrémité qui s'étend radialement en regard de la face transversale d'extrémité sur laquelle il est fixé ;
- le tronçon intermédiaire de suspension s'étend le long d'une partie de la face latérale annulaire cylindrique de la pile électrique ;
- au moins une des pattes de raccordement électrique comporte un tronçon intermédiaire de suspension et un second tronçon d'extrémité qui forment sensiblement un arc de cylindre concentrique à la face latérale annulaire cylindrique de la pile électrique cylindrique ;
- le tronçon intermédiaire de suspension s'étend parallèlement à une face transversale d'extrémité de la pile électrique ;
- le tronçon intermédiaire de suspension s'étend le long de la périphérie de la face transversale d'extrémité de la pile électrique ;
- l'extrémité du tronçon intermédiaire de suspension qui est relié au premier tronçon d'extrémité s'étend de la périphérie de la face transversale d'extrémité de la pile électrique vers le centre de ladite face ;
- le premier tronçon d'extrémité est sensiblement perpendiculaire à ladite extrémité du tronçon intermédiaire de suspension ;
- au moins une des pattes de support et de raccordement comporte un premier tronçon d'extrémité et un tronçon intermédiaire de suspension qui sont situés dans un même plan, et le second tronçon d'extrémité s'étend perpendiculairement dans un plan sensiblement tangent à la face latérale annulaire cylindrique de la pile électrique ;
- chaque patte de raccordement électrique est constituée d'une bande de tôle découpée et pliée ;
- au moins un premier tronçon d'extrémité comporte un évidement destiné à recevoir la soudure.

D'autres caractéristiques et avantages de l'invention apparaîtront à la lecture de la description détaillée qui suit pour la compréhension de laquelle on se reportera aux dessins annexés dans lesquels :
- la figure 1 est une vue en perspective éclatée d'un dispositif de support et de raccordement électrique d'une pile électrique selon un premier mode de réalisation de l'invention qui est représenté au-dessus d'une plaque à circuit imprimé ;
- la figure 2 est une vue du dispositif de support et de raccordement d'une pile électrique selon le premier mode de réalisation qui est représenté en position assemblée et montée sur une plaque à circuit imprimé ;
- la figure 3 représente l'ensemble des deux pattes de raccordement selon le premier mode de réalisation, après l'opération de découpe de leur profil et avant leur pliage ;
- la figure 4 est une vue en coupe à plus grande échelle d'une patte de raccordement selon la ligne 4-4 de la figure 1 ;
- la figure 5 est une vue similaire à celle de la figure 1 selon un deuxième mode de réalisation de l'invention ;
- la figure 6 est une vue similaire à celle de la figure 2 selon le deuxième mode de réalisation.

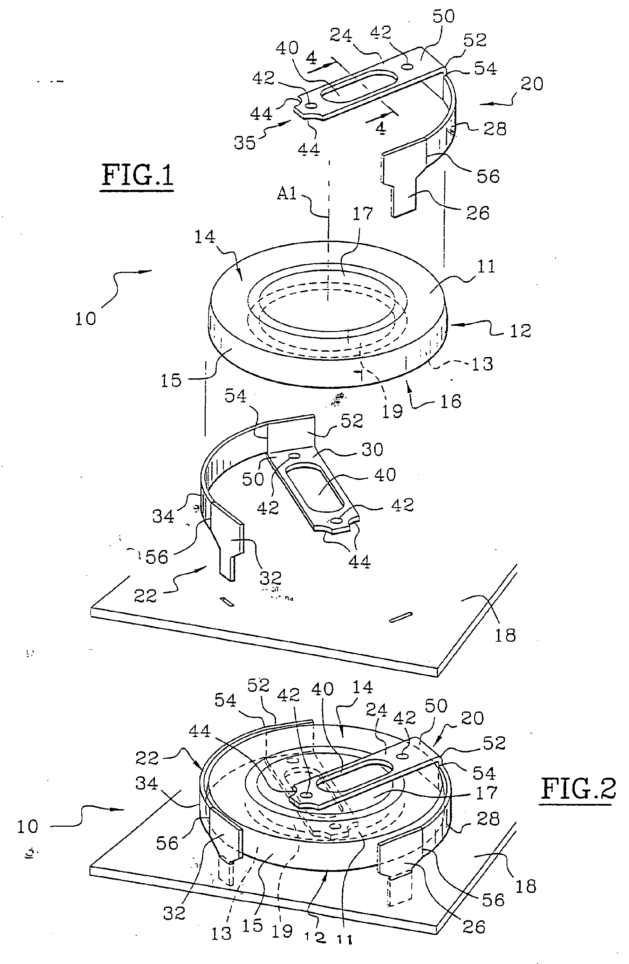

Dans,fa description qui suit, on utilisera à titre non limitatif une orientation supérieure et inférieure, respectivement de haut en bas conformément aux figures 1, 2, 5 et 6.

Sur la figure 1 on a représenté le dispositif 10 de support et de raccordement électrique d'une pile électrique 12, selon un premier mode de réalisation.

La pile électrique 12 est du type "bouton" sensiblement cylindrique d'axe vertical de révolution A1. Elle comporte une face supérieure 14 et une face inférieure 16 reliée par une face latérale annulaire cylindrique 15. Chacune de ses faces transversales supérieure 14 et inférieure 16 comporte ici une partie isolante 11 et 13 respectivement, et un pôle électrique central 17 et 19 de la pile respectivement.

Le dispositif 10 se compose d'une patte supérieure 20 et d'une patte inférieure 22, qui sont réalisées dans une bande de tôle métallique découpée et pliée, chacune comportant une extrémité reliée à la pile électrique 12 et une autre extrémité reliée à un circuit électronique dont la plaque à circuit imprimé 18 est représentée aux figures 1, 2, 5 et 6.

La patte supérieure 20 comporte ainsi un premier tronçon d'extrémité 24, un second tronçon d'extrémité 26, ainsi qu'un tronçon intermédiaire 28 qui, conformément aux enseignements de l'invention, constitue un tronçon de suspension élastique de la pile 12.

De façon similaire, la patte inférieure 22 comporte un premier tronçon d'extrémité 30, un second tronçon d'extrémité 32, ainsi qu'un tronçon intermédiaire de suspension 34.

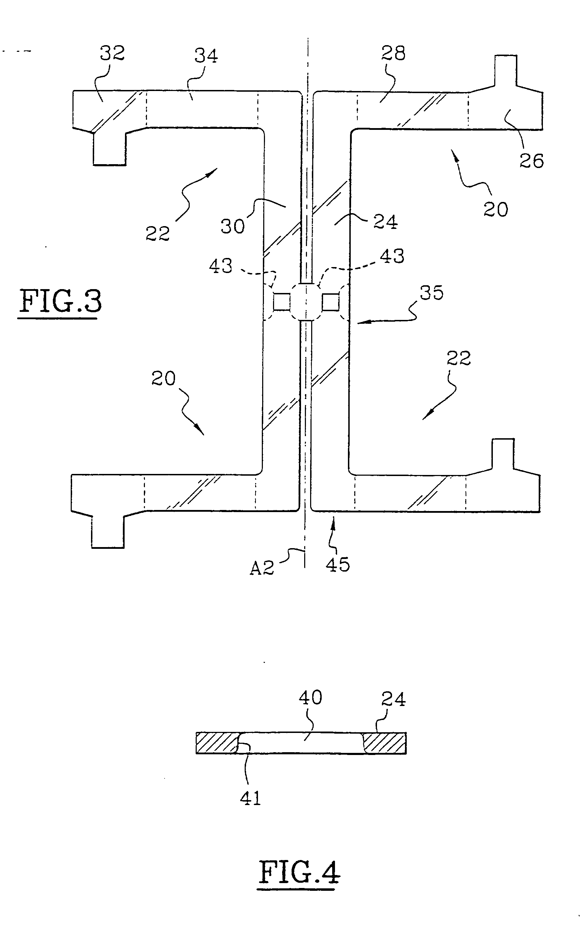

Les pattes de raccordement 20 et 22 sont obtenues par un procédé de découpe tel que l'estampage, d'un flanc de tôle en forme de bande. Les divers tronçons avant le façonnage par pliage des pattes 20, 22 sont référencés à la figure 3.

Après la découpe du contour extérieur des pattes 20, 22, les pattes 20, 22 sont reliées entre elles par l'extrémité libre 35 de leur premier tronçon d'extrémité 24, 30 conformément à la figure 3. Cela permet de faciliter la manipulation de plusieurs pattes à la fois.

Les premiers tronçons d'extrémité 24 et 30 de forme globalement rectangulaire sont situés à l'une des extrémité des tronçons intermédiaires 28, 34. Ils s'étendent parallèlement un axe A2, représenté à la figure 3, et ils sont chacun orthogonal au dit tronçon intermédiaire correspondant.

Les seconds tronçons d'extrémité 26 et 32 sont situés à l'autre extrémité des tronçons intermédiaires 28, 34, ils ont sensiblement la forme d'un T.

Après avoir réalisé les pattes supérieure 20 et inférieure 22, divers opération complémentaire sont réalisées dans les premiers tronçons d'extrémité 24, 30.

Une boutonnière ou évidemment 40 est réalisée dans la partie centrale des premiers tronçons d'extrémité 24, 30. Le bord 41, représenté à la figure 4, qui délimite la boutonnière 40 dans l'épaisseur des premiers tronçons d'extrémité 24, 30 présente un profil évasé en forme de cloche. Ainsi les périmètres de la boutonnière 40 sur chacune des faces supérieure et inférieure des premiers tronçons d'extrémité 24, 30 sont différents.

Les pattes 22 et 24 sont réalisées de façon que la face qui présente le périmètre le plus important soit celle qui est en contact avec la face transversale respective de la pile électrique 12.

La boutonnière 40 permet, lors de l'assemblage du dispositif 10 de recevoir une goutte de soudure ou tout autre élément de fixation élément de fixation, tel que de la colle, entre la pile 12 et les pattes 20, 22.

Deux perçages 42 sont réalisés de part et d'autre de la boutonnière 40. Ils permettent lors de la fabrication des pattes 20, 22 le passage d'outils de maintien qui immobilisent les pattes 20, 22 au cours des opérations telle que le pliage ou le cintrage.

Deux empreintes 44 sont réalisées au niveau des deux coins de la première extrémité libre 35 en contact avec la pile électrique 12, de chacun des deux premiers tronçons d'extrémité 24, 30. Les empreintes 44 ont chacune la forme d'un quart de cercle concave.

Les empreintes 44 sont réalisées par poinçonnage de l'ensemble des pattes 20 et 22 selon les pointillés 43 conformément à la figure 3, cette opération permettant de séparer chaque patte de raccordement électrique 20, 22.

De plus, un pliage transversal est réalisé sur chacun des premiers tronçons d'extrémité 24, 30, à proximité de leur seconde extrémité libre 45. Ces pliages délimitent une première 50 et une seconde 52 parties qui forment entre elles un angle d'environ 90 degrés.

Ainsi, en position montée, conformément à la figure 2, la première partie horizontale 50 du premier tronçon 24 de la patte supérieure 20 est en contact avec la face transversale supérieure 14 de la pile 12. De façon symétrique, la première partie horizontale 50 du premier tronçon 30 de la patte inférieure 22 est en contact avec la face transversale inférieure 16 de la pile 12 et la seconde partie verticale 52 des deux premiers tronçons 24, 30 est dans un plan tangent à la face latérale annulaire cylindrique 15 de la pile 12.

Les seconds tronçons d'extrémité de fixation 26 et 32 ayant sensiblement la forme d'un T, la partie supérieure horizontale, conformément aux figures 1 et 2, se raccorde à une extrémité libre du tronçon intermédiaire de suspension 28, 34 respectivement. Une partie inférieure verticale constitue l'élément qui permet la fixation et le raccordement électrique des pattes 20, 22 avec le circuit électronique 18. La fixation et le raccordement électrique sont de préférence réalisés par piquage et par soudage.

Les tronçons intermédiaires de suspension 28 et 34 sont ici cintrés en arcs de cylindre d'un diamètre supérieur au diamètre extérieur de la face latérale 15 pile électrique 12.

Lors du montage, les premiers tronçons 24 et 30 s'étendent radialement le long des faces transversales d'extrémité supérieure 14 et inférieure 16 respectivement de la pile électrique 12.

De plus, les premiers tronçons d'extrémité 24 et 30 sont fixés sur la pile de façon que les tronçons intermédiaires de suspension 28 et 30 soient disposés angulairement sensiblement symétriquement de part et d'autre de la pile 12.

Lorsque le télécommande est soumise à des vibrations, la pile suspendue 12 se déplace alors par rapport aux seconds tronçons d'extrémité 26, 32. Le moment relatif de la pile 12 par rapport au circuit électronique 18 provoque des contraintes à l'intérieur des pattes de fixation 20, 22 ainsi qu'à l'intérieur des fixations des pattes 20, 22 avec la pile 12 et le circuit électronique 18. Grâce à l'élasticité de la tôle, les tronçons intermédiaires de suspension 28 et 34 jouent le rôle d'un amortisseur élastique entre les premiers tronçons 24, 30 et les seconds tronçons 26, 32 d'extrémité. Ils amortissent les chocs et vibrations, et ils diminuent l'amplitude des déplacements de la pile 12. Ainsi, les contraintes existantes à l'intérieur des fixations notamment, dans les soudures entre les premiers tronçons d'extrémité 24, 30 et la pile 12, sont réduites et restent inférieures à la contrainte de rupture de la fixation.

La disposition des tronçons intermédiaires 28 et 34 de façon parallèle à la face latérale 15 de la pile selon le premier mode de réalisation est bien adaptée pour réaliser le découplage mécanique de la pile 12 et du circuit électronique 18 lorsque les vibrations principalement sont dans un plan perpendiculaire à l'axe A1.

Avantageusement, des plis 54 et 56 sont marqués d'une part entre les tronçons intermédiaires 28, 34 et, d'autre part, entre les premiers tronçons d'extrémité 24, 30 et les seconds tronçons d'extrémité 26, 32 respectivement. Ces plis 54 et 56 permettent de réaliser une discontinuité locale dans la structure de la matière des pattes de raccordement électrique 20, 22 ce qui augmente l'efficacité du découplage mécanique entre la pile électrique 12 et le circuit électronique 18.

Selon une variante, non représentée, les premiers tronçons d'extrémité 20 et 22, les tronçons intermédiaires de suspensions 28, 34 et les seconds tronçons d'extrémité 26 et 32 sont réalisés en trois parties distinctes, puis sont soudés.

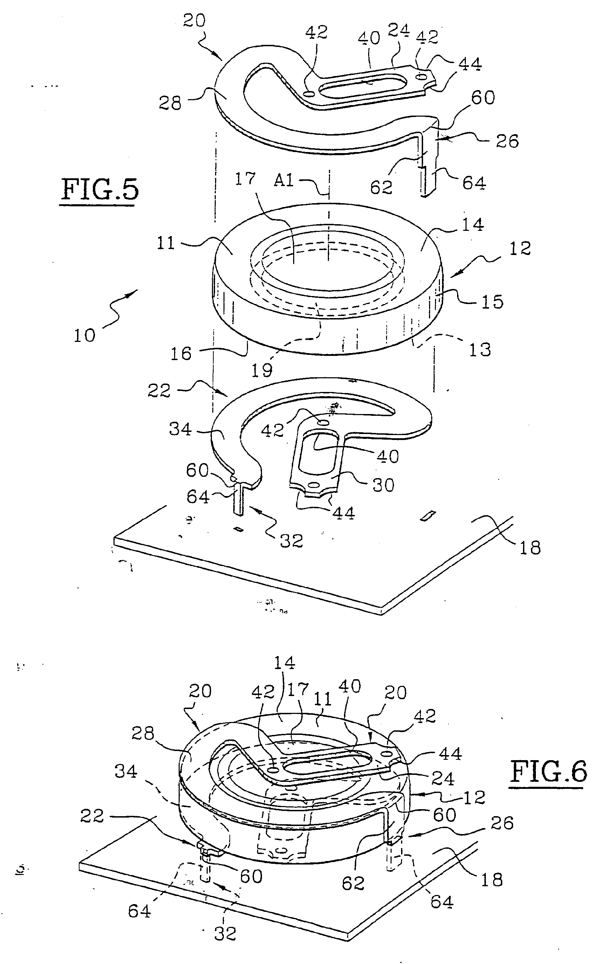

Les figures 5 et 6 illustrent un dispositif 10 de support et de raccordement électrique selon un deuxième mode de réalisation.

Les éléments identiques, similaires ou équivalents à ceux du premier mode de réalisation seront repérés par les mêmes références.

Le dispositif 10 qui supporte la pile électrique 12 et la raccorde électriquement à un circuit électronique 18 comporte ainsi d'une part une patte supérieure 20 qui est constituée d'un premier tronçon d'extrémité de raccordement 24, d'un second tronçon d'extrémité de fixation 26 et d'un tronçon intermédiaire de suspension 28 et, d'autre part, une patte inférieure 22 qui est constituée d'un premier tronçon d'extrémité 30, d'un second tronçon d'extrémité 32 d'un tronçon intermédiaire 34.

Les premiers tronçons intermédiaires 24 et 30 comportent les mêmes formes et découpes que dans le premier mode de réalisation.

Le second tronçon vertical 26 a une forme générale en T dont le bord supérieur 60 de sa branche supérieure horizontale 62 se raccorde à angle droit avec le tronçon intermédiaire horizontal de suspension 28. La hauteur de la partie supérieure horizontale 62 correspond sensiblement à l'épaisseur de la pile 12 et la hauteur de la bande inférieure verticale 64 correspond à la hauteur nécessaire à la fixation par piquage de la patte de raccordement 20 sur le circuit électronique 18.

Le second tronçon 32 de la patte inférieure 22 est similaire au second tronçon 26, à la différence près que sa branche supérieure horizontale est quasiment inexistante du fait que la patte 22 est située sur la partie inférieure de la pile 12.

Les tronçons intermédiaires de suspension 28 et 34 sont constitués d'une bande de tôle en forme générale de spirale et chacune est reliée par ses extrémités au premier et au second tronçons respectifs.

Leurs formes et leurs dimensions sont telles que, après la fixation par soudage des premiers tronçons d'extrémité 24, 30 sur la pile 12, les tronçons intermédiaires 28 et 34 s'étendent, du bord supérieur 60 de la branche supérieure horizontale 62 des seconds tronçons d'extrémité 26, 32, dans le même plan horizontal que les premiers tronçons 24, 30.

De plus, ils suivent les bords circulaires des faces transversales d'extrémité supérieure 14 et inférieure 1ô respectivement de la pile 12 sur environ la moitié de la circonférence de cette dernière. Ensuite, les tronçons intermédiaires 28 et 34 s'orientent vers l'axe A1 de la pile 12 de façon qu'ils rejoignent une extrémité des premiers tronçons 24 et 30 qui sont disposés sensiblement selon un rayon de la pile 12.

Ainsi, lorsque la pile électrique 12 vibre, les tronçons intermédiaires de suspension 28, 34 jouent le rôle d'une spire d'un ressort hélicoïdal. Les vibrations sont amorties et les contraintes existantes à l'intérieur des fixations, et notamment des soudures entre les premiers tronçons d'extrémité 24, 30 et, les faces supérieure 14 et inférieure 16 respectivement de la pile électrique 12, sont fortement limitées. Le dispositif 10 permet d'accroître fortement la durée de vie des soudures.

La disposition en spirale sur la face transversale d'extrémité de la pile 12 des premiers tronçons d'extrémité 24, 30, selon le second mode de réalisation, est bien adaptée pour réaliser le découplage mécanique de la pile 12 et du circuit électronique 18 selon une direction principale parallèle à l'axe A1.

Dans un troisième mode de réalisation non représenté, le dispositif 10 de support et de raccordement électrique de la pile électrique 12 et du circuit électronique 18 est par exemple constitué de la patte de raccordement 20 selon le premier mode de réalisation et de la patte de raccordement 22 selon le deuxième mode de réalisation.

Dans un quatrième mode de réalisation non représenté, chaque patte du dispositif 10 de support et de raccordement électrique de la pile 12 est une combinaison des deux premiers modes de réalisation de chaque patte selon l'invention.

## Revendications

1. Dispositif de support et de raccordement (10) d'une pile électrique (12) qui comporte deux pôles (17, 19), à un circuit électronique (18), du type qui comprend des pattes (20, 22) de support et de raccordement électrique qui se constituent chacune d'un premier tronçon d'extrémité (24, 30) qui est fixé par soudage et qui est en contact électrique avec un pôle (17, 19) respectif de la pile électrique (12), et d'un second tronçon d'extrémité (26, 32) qui est fixé sur le circuit électronique (18) et qui est en contact électrique avec une piste de circuit (18),
**caractérisé en ce qu'**au moins une des pattes (20, 22) de raccordement électrique comporte un tronçon intermédiaire de suspension (28, 34) entre lesdits premiers et seconds tronçons d'extrémité et qui réalise un découplage mécanique entre la pile électrique (12) et le circuit électronique (18).

2. Dispositif selon la revendication précédente, **caractérisé en ce que** la pile électrique (12) est cylindrique et que chacune de ses faces (14, 16) transversales opposées d'extrémité comporte un pôle électrique (17, 19).

3. Dispositif selon la revendication précédente, **caractérisé en ce qu'**au moins une des pattes (20, 22) de raccordement électrique comporte un premier tronçon d'extrémité (24, 30) qui s'étend radialement en regard de la face (14, 16) transversale d'extrémité sur laquelle il est fixé.

4. Dispositif selon l'une des revendications 2 ou 3, **caractérisé en ce que** le tronçon intermédiaire de suspension (28, 34) s'étend le long d'une partie de la face latérale annulaire cylindrique de la pile électrique (12).

5. Dispositif selon l'une des revendications 2 à 4, **caractérisé en ce qu'**au moins une des pattes (20, 22) de raccordement électrique comporte un tronçon intermédiaire de suspension (28, 34) et un second tronçon d'extrémité (26, 32) qui forment sensiblement un arc de cylindre concentrique à la face latérale annulaire cylindrique de la pile électrique cylindrique (12).

6. Dispositif selon l'une des revendications 2 ou 3, **caractérisé en ce que** le tronçon intermédiaire de suspension (28, 34) s'étend parallèlement à une face (14, 16) transversale d'extrémité de la pile électrique (12).

7. Dispositif selon la revendication précédente **caractérisé en ce que** le tronçon intermédiaire de suspension (28, 34) s'étend le long de la périphérie de la face (14,16) transversale d'extrémité de la pile électrique (12).

8. Dispositif selon la revendication précédente, **caractérisé en ce que** l'extrémité du tronçon intermédiaire de suspension (28, 34) qui est relié au premier tronçon d'extrémité (24, 30) s'étend de la périphérie de la face (14, 16) transversale d'extrémité de la pile électrique (12) vers le centre de ladite face.

9. Dispositif selon la revendication précédente, **caractérisé en ce que** le premier tronçon d'extrémité (24, 30) est sensiblement perpendiculaire à ladite extrémité du tronçon intermédiaire de suspension (24, 30).

10. Dispositif selon l'une quelconque des revendications 2 ou 3 et 6 à 9, **caractérisé en ce qu'**au moins une des pattes (20, 22) de support et de raccordement comporte un premier tronçon d'extrémité (24, 30) et un tronçon intermédiaire de suspension (28, 34) qui sont situés dans un même plan, et **en ce que** le second tronçon d'extrémité (26, 32) s'étend perpendiculairement dans un plan sensiblement tangent à la face latérale annulaire cylindrique de la pile électrique (12).

11. Dispositif selon l'une quelconque des revendications précédentes, **caractérisé en ce que** chaque patte (20, 22) de raccordement électrique est constituée d'une bande de tôle découpée et pliée.

12. Dispositif selon l'une quelconque des revendications précédentes, **caractérisé en ce qu'**au moins un premier tronçon d'extrémité (24, 30) comporte un évidement (40) destiné à recevoir la soudure.

## Claims

1. Support device (10) for the connection of an electrical battery (12) that comprises two poles (17, 19) to an electronic circuit (18) of the type including support and electrical connection tabs (20, 22) each of which forms a first end segment (24, 30) that is fixed by welding and is in electrical contact with a corresponding pole (17, 19) of the electrical battery (12), and a second end segment (26, 32) that is fixed onto the electronic circuit (18) and is in electrical contact with a circuit track (18),
**characterised in that** at least one of the electrical connection tabs (20, 22) comprises an intermediate suspension segment (28, 34) between the said first and second end segments and that makes mechanical decoupling between the electrical battery (12) and the electronic circuit (18).

2. Device according to the above claim, **characterised in that** the electrical battery (12) is cylindrical and that each of its opposite transverse end faces (14, 16) comprises an electrical pole (17, 19).

3. Device according to the above claim, **characterised in that** at least one of the electrical connection tabs (20, 22) comprises a first end segment (24, 30) that extends radially facing the transverse end face (14, 16) to which it is fixed.

4. Device according to either claim 2 or 3, **characterised in that** the intermediate suspension segment (28, 34) extends along a part of the cylindrical annular side face of the electrical battery (12).

5. Device according to one of claims 2 to 4, **characterised in that** at least one of the electrical connection tabs (20, 22) comprises an intermediate suspension segment (28, 34) and a second end segment (26, 32) that approximately form an arc of a cylinder concentric with the cylindrical annular side face of the cylindrical electrical battery (12).

6. Device according to either claim 2 or 3, **characterised in that** the intermediate suspension segment (28, 34) extends parallel to a transverse end face (14, 16) of the electrical battery (12).

7. Device according to the above claim, **characterised in that** the intermediate suspension segment (28, 34) extends along the periphery of the transverse end face (14,16) of the electrical battery (12).

8. Device according to the above claim, **characterised in that** the end of the intermediate suspension segment (28, 34) that is connected to the first end segment (24, 30) extends from the periphery of the transverse end face (14, 16) of the electrical battery (12) towards the centre of the said face.

9. Device according to the above claim, **characterised in that** the first end segment (24, 30) is substantially perpendicular to the said end of the intermediate suspension segment (24, 30).

10. Device according to either claim 2 or 3 and to any one of claims 6 to 9, **characterised in that** at least one of the support and connection tabs (20, 22) comprises a first end segment (24, 30) and an intermediate suspension segment (28, 34) that are located in the same plane, and **in that** the second end segment (26, 32) extends perpendicularly in a plane approximately tangent to the cylindrical annular side face of the electrical battery (12).

11. Device according to any one of the above claims, **characterised in that** each electrical connection tab (20, 22) of the is composed of a cut and bent strip of plate.

12. Device according to any one of the above claims, **characterised in that** at least a first end segment (24, 30) comprises a recess (40) designed to contain the weld.

## Patentansprüche

1. Vorrichtung (10) zur Halterung und Verbindung einer zwei Pole (17, 19) aufweisenden Batterie (12) mit einer elektronischen Schaltung (18), vom Typ, der Laschen (20, 22) zur Halterung und elektrischen Verbindung aufweist, die jeweils aus einem ersten Endabschnitt (24, 30), der durch Löten befestigt ist und sich mit einem jeweiligen Pol (17, 19) der Batterie (12) in elektrischem Kontakt befindet, und aus einem zweiten Endabschnitt (26, 32) gebildet sind, welcher an der elektronischen Schaltung (18) befestigt ist und sich mit einer Leiterbahn der Schaltung (18) in elektrischem Kontakt befindet,
**dadurch gekennzeichnet, dass** mindestens eine der Laschen (20, 22) zur elektrischen Verbindung zwischen dem ersten und dem zweiten Endabschnitt einen Aufhängungszwischenabschnitt (28, 34) aufweist, der eine mechanische Entkoppelung zwischen der Batterie (12) und der elektronischen Schaltung (18) realisiert.

2. Vorrichtung nach dem vorhergehenden Anspruch, **dadurch gekennzeichnet, dass** die Batterie (12) zylindrisch ist und dass jede ihrer entgegengesetzten Endquerflächen (14, 16) einen elektrischen Pol (17, 19) aufweist.

3. Vorrichtung nach dem vorhergehenden Anspruch, **dadurch gekennzeichnet, dass** mindestens eine der Laschen (20, 22) zur elektrischen Verbindung einen ersten Endabschnitt (24, 30) aufweist, der sich gegenüber von der Querendfläche (14,16), an der er befestigt ist, radial erstreckt.

4. Vorrichtung nach Anspruch 2 oder 3, **dadurch gekennzeichnet, dass** sich der Aufhängungszwischenabschnitt (28, 34) entlang einem Teil der ringförmigen, zylindrischen Seitenfläche der Batterie (12) erstreckt.

5. Vorrichtung nach einem der Ansprüche 2 bis 4, **dadurch gekennzeichnet, dass** mindestens eine der Laschen (20, 22) zur elektrischen Verbindung einen Aufhängungszwischenabschnitt (28, 34) und einen zweiten Endabschnitt (26, 32) aufweist, die im Wesentlichen einen Zylinderbogen bilden, der zur ringförmigen, zylindrischen Seitenfläche der zylindrischen Batterie (12) konzentrisch ist.

6. Vorrichtung nach Anspruch 2 oder 3, **dadurch gekennzeichnet, dass** sich der Aufhängungszwischenabschnitt (28, 34) parallel zu einer Querendfläche (14, 16) der Batterie (12) erstreckt.

7. Vorrichtung nach dem vorhergehenden Anspruch, **dadurch gekennzeichnet, dass** sich der Aufhängungszwischenabschnitt (28, 34) entlang dem Umfang der Querendfläche (14,16) der Batterie (12) erstreckt.

8. Vorrichtung nach dem vorhergehenden Anspruch, **dadurch gekennzeichnet, dass** das Ende des Aufhängungszwischenabschnitts (28, 34), der mit dem ersten Endabschnitt (24, 30) verbunden ist, sich von dem Umfang der Querendfläche (14, 16) der Batterie (12) zur Mitte der Fläche erstreckt.

9. Vorrichtung nach dem vorhergehenden Anspruch, **dadurch gekennzeichnet, dass** der erste Endabschnitt (24, 30) im Wesentlichen senkrecht zu dem Ende des Authängungszwischenabschnitts (28, 34) verläuft.

10. Vorrichtung nach einem der Ansprüche 2 oder 3 und 6 bis 9, **dadurch gekennzeichnet, dass** mindestens eine der Laschen (20, 22) zur Halterung und Verbindung einen ersten Endabschnitt (24, 30) und einen Aufhängungszwischenabschnitt (28, 34) aufweist, die sich in ein und derselben Ebene befinden, und dass sich der zweite Endabschnitt (26, 32) in einer Ebene senkrecht erstreckt, welche zur ringförmigen, zylindrischen Seitenfläche der Batterie (12) im Wesentlichen tangential verläuft.

11. Vorrichtung nach einem der vorhergehenden Ansprüche, **dadurch gekennzeichnet, dass** jede Lasche (20, 22) zur elektrischen Verbindung aus einem gestanzten und gefalteten Blechstreifen besteht.

12. Vorrichtung nach einem der vorhergehenden Ansprüche, **dadurch gekennzeichnet, dass** mindestens ein erster Endabschnitt (24, 30) eine Ausnehmung (40) aufweist, die für die Aufnahme des Lots vorgesehen ist.
